# EUROPEAN PATENT SPECIFICATION

(11) **EP 3 181 649 B1**
(45) Date of publication and mention of the grant of the patent: **22.04.2020**
(21) Application number: 16764660.3
(22) Date of filing: 25.02.2016
(51) Int. Cl.: C09J 133/14, C09J 11/04, C09J 11/06, C09J 133/06, C09J 163/00, C09J 167/06, C09J 175/04, H01L 31/049

(54) **POLYOL COMPOSITION, ADHESIVE COATING MATERIAL, CURED OBJECT OBTAINED THEREFROM, ADHESIVE SHEET, AND SOLAR CELL MODULE**
POLYOLZUSAMMENSETZUNG, HAFTÜBERZUG, DARAUS GEWONNENES GEHÄRTETES OBJEKT, HAFTFOLIE UND SOLARZELLENMODUL
COMPOSITION DE POLYOL, MATIÈRE DE REVÊTEMENT ADHÉSIF, OBJET DURCI OBTENU À PARTIR DE CELLE-CI, FEUILLE ADHÉSIVE ET MODULE DE CELLULE SOLAIRE

(30) Priority: 13.03.2015 JP 2015050771
(43) Date of publication of application: 21.06.2017
(73) Proprietor: DIC Corporation, Tokyo 174-8520 (JP)
(72) Inventor: TAKEDA, Miho, Tokyo 174-8520 (JP); MATSUO, Takatoshi, Tokyo 174-8520 (JP); KOUYAMA, Tatsuya, Tokyo 174-8520 (JP); TAKEUCHI, Kan, Ichihara-shi Chiba 290-8585 (JP); HIROTA, Yasunobu, Ichihara-shi Chiba 290-8585 (JP)
(74) Representative: Beckmann, Claus
(86) International application number: PCT/JP2016/055595
(87) International publication number: WO 2016/147830

(56) References cited:
- EP-A1- 0 554 780
- WO-A1-2007/066827
- WO-A1-2007/108314
- WO-A1-2011/034070
- WO-A1-2013/118575
- WO-A1-2014/185544
- GB-A- 2 131 438
- JP-A- H04 255 782
- JP-A- 2009 179 710
- JP-A- 2011 071 387
- JP-A- 2013 143 458
- JP-A- 2013 209 554
- JP-A- 2013 227 520
- JP-A- 2014 160 810
- JP-A- 2014 160 810

## Description

### Technical Field

The present invention relates to an adhesive coating material which exhibits excellent adhesion between a solar cell sealing material and a base sheet, a polyol composition for the coating material, a cured object of the adhesive coating material, an adhesive sheet having excellent adhesive strength and moist-heat resistance, and a solar cell module using the sheet.

### Background Art

In recent years, depletion of fossil fuels such as petroleum and coal is feared, and thus development for securing alternative energy obtained from these fossil fuels is urgent. In the alternative energy of the fossil fuels, solar power which is capable of directly converting solar energy into electric energy is going to proceed to the practical use as a semi-permanent and pollution-free new energy source, and is highly expected as a clean energy source with the remarkable improvement in the price performance ratio when it is actually used.

A solar cell used in the solar power is a main part of a solar power system in which the solar energy is directly converted into the electric energy, and is formed of a semiconductor representative of silicon or the like. The structure of the solar cell is unitized by wiring the solar cells in series and in parallel, and performing various packagings in order to protect the cells. A unit obtained by being built into such a package is called a solar cell module, and has a configuration in which a light receiving surface on which sun light is typically incident is covered with a front surface protection member such as a glass plate, and a gap between the solar cell and the front surface protection member is sealed by using a thermoplastic resin, and a back surface protection sheet is disposed.

Since the aforementioned solar cell module is used outdoors for a long period of time, for example, approximately 30 years in general, an ethylene-vinyl acetate copolymer resin with high transparency and excellent moist resistance is widely used as material for sealing the solar cell and the front surface protection member. In addition, as the back surface protection sheet (back sheet), a laminated sheet in which a polyester sheet such as a polyethylene terephthalate resin is set as a base sheet, both sides of the base sheet are coated with an adhesive, and fluororesin sheets such as polyvinyl fluoride, polyvinylidene fluoride, polytetrafluoroethylene, and polychlorotrifluoroethylene with excellent weather resistance are laminated thereon, and a sheet which exhibits water vapor barrier performance by further laminating metal foils such as aluminum foils are widely used.

Although the laminated sheet in which the fluororesin sheet is provided as described above serves as a back sheet with excellent weather resistance, it was expensive. In addition, the back sheet had sufficient practical adhesive strength, but could not avoid a phenomenon that the adhesive strength of an interface between the fluororesin sheet and the base sheet is decreased with time due to the long-term use under the moist-heat environment, and thus was not able to correspond to more advanced long-term reliability and durability which are required in recent years. Further, an adhesive coating step and a fluororesin sheet laminating step are required, and thus productivity and manufacturing cost had to be increased.

For this reason, in recent years, means for coating the surface on sealing material side of the base sheet with an easy adhesive agent instead of laminating the above-described fluororesin sheet on a surface being in contact with a solar cell sealing material in the back sheet is widely used.

In the back sheet using the easy adhesive agent, when peeling of the base sheet from the back sheet is caused, it is not possible to protect the solar cell from moisture and external factors, which causes an output of the solar cell to be deteriorated and thus high adhesion and adhesive durability are required for an easy adhesive agent layer. For this reason, for the easy adhesive agent, it is necessary to secure not only adhesion with the solar cell sealing material but also the adhesion with the base sheet such as a PET sheet.

In this regard, there is provided a technique of using a 2-pack type liquid adhesive including, as essential components, an acrylic polymer having an acryloyl group and a hydroxyl group, which is obtained by reacting an acrylic acid with a hydroxy group-containing acrylic oligomer, and a polyisocyanate component as an easy adhesive agent having excellent adhesive durability (refer to the following PTL 1) .

However, the easy adhesive agent disclosed in PTL 1 realizes excellent adhesion, but greatly shrinks at the time of crosslinking an acryloyl group, and thus cannot sufficiently secure the adhesion to a base sheet such as PET. Further, the easy adhesive agent causes a decrease in the adhesive strength with time under the moist-heat environment.

### Citation List

### Patent Literature

[PTL: 1] JP-A-2013-136665, further relevant are EP-A-554780, GB-A-2131438, WO-A-2013/118575, US-A-2016/064585, JP-A-2014/160810.

### Summary of Invention

### Technical Problem

Accordingly, an object of the present invention is to provide an adhesive coating material which realizes excellent adhesive strength and moist-heat resistance at the time of bonding a solar cell sealing material and a base sheet, a polyol composition for the coating material, a cured object of the adhesive coating material, an adhesive sheet obtained by coating with the adhesive coating material, and a solar cell module using the sheet.

### Solution to Problem

The present inventors have conducted intensive studies in order to achieve the above object, and completed the present invention based on the result that a two-pack curing-type adhesive coating material in which a material obtained by mixing unsaturated double bond-containing polyester polyol into a hydroxyl group-containing (meth)acrylic resin is used as a polyol component which is a main agent, and a polyisocyanate compound is used as a curing agent realizes excellent adhesion with a solar cell sealing material while maintaining excellent adhesion with a base sheet such as a PET sheet.

That is, the present invention relates to a polyol composition for a polyisocyanate curing-type adhesive coating material, which contains a hydroxyl group-containing (meth)acrylic resin (I) and unsaturated double bond-containing polyester polyol (II) and a hydroxyl group containing polycarbonate (IV) as essential components.

The present invention further relates to an adhesive coating material which contains the polyol composition (α) and a polyisocyanate compound (β) as essential components.

The present invention further relates to a cured object obtained by curing the adhesive coating material.

The present invention further relates to an adhesive sheet including a polyester base sheet having thereon an adhesive layer formed by coating the polyester base sheet with the adhesive coating material and curing the adhesive coating material.

The present invention further relates to a solar cell module which includes a solar cell (A), a surface protective base material (B), a sealing material for solar cell (D), and a back sheet (E) as essential components, in which the back sheet (E) includes a base sheet (a) and an adhesive layer (b) which is formed on the base sheet (a) and is a cured object of the adhesive coating material according to claim 13 as an essential layer configuration, and the back sheet (E) is disposed such that the adhesive layer (b) is in contact with the sealing material for solar cell (D).

### Advantageous Effects of Invention

According to the present invention, there is provided an adhesive coating material which realizes excellent adhesive strength and moist-heat resistance at the time of bonding a solar cell sealing material and a base sheet, a polyol composition for the coating material, a cured object of the adhesive coating material, an adhesive sheet obtained by being coated with adhesive coating material, and a solar cell module using the sheet.

### Brief Description of Drawing

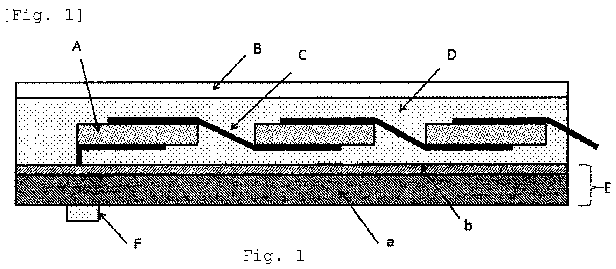

Fig. 1 is a sectional view of one example of a solar cell module of the present invention.

### Description of Embodiments

A polyol composition for a polyisocyanate curing-type adhesive coating material (hereinafter, simply abbreviated as a "polyol composition") of the present invention is used as a main agent of an adhesive coating material for forming a back sheet of a solar cell module. Note that, a polyisocyanate compound described below is used as the curing agent. In addition, the adhesive coating material is not only used for the back sheet of a solar cell module, but also used in a case of using a resin sheet as an alternative material of a surface protective glass of the solar cell module, as an adhesive coating material of the resin sheet.

Here, a hydroxyl group-containing (meth)acrylic resin (I) for constituting the polyol composition of the present invention is obtained by copolymerizing hydroxyl group-containing (meth)acrylate (a) and other (meth)acrylic monomers (b) as essential components.

Here, examples of the hydroxyl group-containing (meth)acrylate (a) include 2-hydroxyethyl (meth)acrylate, 2-hydroxypropyl (meth)acrylate, 4-hydroxybutyl (meth)acrylate, polyethylene glycol mono (meth)acrylate, and polypropylene glycol mono (meth)acrylate.

In addition, examples of other (meth)acrylic monomers (b) include (meth) acrylate (b-1) esterified with an alkyl group having 1 to 3 carbon atoms such as methyl (meth) acrylate, n-propyl (meth)acrylate, isopropyl (meth)acrylate; (meth)acrylate (b-2) esterified with an alkyl group having 4 to 16 carbon atoms such as n-butyl (meth)acrylate, isobutyl (meth)acrylate, s-butyl (meth)acrylate, t-butyl (meth)acrylate, n-pentyl (meth)acrylate, isoamyl (meth)acrylate, neopentyl (meth)acrylate, n-hexyl (meth)acrylate, n-heptyl (meth)acrylate, n-octyl (meth)acrylate, isooctyl (meth)acrylate, 2-ethylhexyl (meth)acrylate, n-nonyl (meth)acrylate, isononyl (meth)acrylate, n-decyl (meth)acrylate, isodecyl (meth)acrylate, undecyl (meth)acrylate, dodecyl (meth)acrylate, tridecyl (meth)acrylate, tetradecyl (meth)acrylate, pentadecyl (meth)acrylate hexadecyl (meth)acrylate, cyclohexyl (meth)acrylate, bornyl (meth)acrylate, and isobornyl (meth)acrylate; and (meth)acrylic acid (b-3).

In the present invention, as the above-described other (meth)acrylic monomers (b), (meth)acrylate (b-2) esterified with an alkyl group having 4 to 16 carbon atoms is preferably used as an essential monomer component in order to remarkably improve the adhesion to a base sheet such as PET, and realize more excellent adhesive strength and moist-heat resistance. Among the (meth)acrylates (b-2), (meth)acrylate selected from the group consisting of cyclohexyl (meth)acrylate, isobutyl (meth)acrylate, n-butyl (meth)acrylate, t-butyl (meth)acrylate, 2-ethylhexyl (meth)acrylate, and lauryl (meth) acrylate are particularly preferable in order to realize an effect of improving the adhesion with the base sheet.

According to the present invention, when the above-described hydroxyl group-containing (meth)acrylic resin (I) is prepared, it is possible to adjust the polarity of the adhesive coating material itself in an optimal range in accordance with the composition ratio of the monomer components such that the adhesion with the base sheet becomes excellent. From the above description, it is preferable to use the hydroxyl group-containing (meth)acrylate (a), (meth)acrylate (b-1) esterified with an alkyl group having 1 to 3 carbon atoms, and (meth)acrylate (b-2) esterified with an alkyl group having 4 to 16 carbon atoms as the essential monomer components, and the hydroxyl group-containing (meth)acrylate (a), the (meth)acrylate (b-1) esterified with an alkyl group having 1 to 3 carbon atoms, and (meth)acrylate (b-2) esterified with an alkyl group having 4 to 16 carbon atoms are preferably used such that content ratios thereof are in a range of 3% to 20% by mass, 15% to 50% by mass, and 30% to 76% by mass, respectively, with respect to the monomer components for forming the hydroxyl group-containing (meth)acrylic resin (I). In addition, a (meth)acrylic acid (b-3) is preferably used in the content ratio of 0.1% to 5% by mass with respect to the monomer components.

In addition, in the hydroxyl group-containing acrylic resin (I), in addition to the above-described monomers, an aromatic vinyl compound such as styrene and methyl styrene may be used together as a raw material monomer to the extent that the effect of the present invention is not impaired, for example, in a range of equal to or less than 3% by mass.

The hydroxyl group-containing acrylic resin (I) used in the present invention can be prepared through radical polymerization reaction of, for example, the hydroxyl group-containing (meth)acrylate (a) with other (meth)acrylic monomers (b) by using a radical polymerization initiator such as benzoyl peroxide, azobisisobutyronitrile, 2,2'-azobis (2-methyl butyronitrile), t-butyl peroxy-2-ethyl hexanoate, 1,1-di(t-butyl peroxy)cyclohexane, t-amyl peroxy-2-ethyl hexanoate, t-butyl peroctoate, di-t-butyl peroxide, and t-butyl perbenzoate. In this case, these radical polymerization initiators may be used alone or two or more types thereof may be used in combination. In addition, it is preferable that such a radical polymerization reaction is typically performed at a temperature of 60°C to 150°C in an organic solvent such as a hydrocarbon solvent such as toluene, xylene, cyclohexane, n-hexane, and octane; an ester solvent such as methyl acetate, ethyl acetate, n-butyl acetate, isobutyl acetate, n-propyl acetate, amyl acetate, propylene glycol monomethyl ether acetate, propylene glycol monoethyl ether acetate, and ethoxyethyl propionate; an ether solvent such as diethylene glycol dimethyl ether; and a ketone solvent such as acetone, methyl ethyl ketone, methyl isobutyl ketone, and cyclohexanone, or in two or more mixed solvents thereof.

In the hydroxyl group-containing acrylic resin (I) obtained as described above, a hydroxyl value is preferably from 1 to 200 mgKOH/g in terms of the adhesive strength and the moist-heat resistance, and number average molecular weight (Mn) thereof is preferably from 5,000 to 500,000 in order to realize the excellent adhesive strength and moist-heat resistance.

Next, the unsaturated double bond-containing polyester resin (II) used for the polyol composition of the present invention is obtained by causing a polyol component (II-1), a dicarboxylic acid component (II-2), and a monocarboxylic acid component (II-3) as necessary to react with each other, and when any one of the aforementioned components which contains an unsaturated double bond is used, it is possible to introduce the unsaturated double bond into a resin structure. In the present invention, the high adhesion and adhesive durability with solar cell sealing material are realized by using such an unsaturated double bond-containing polyester resin (II).

When classifying the unsaturated double bond-containing polyester resin (II) from the combination of raw material components, for example, the following polyhydric aliphatic alcohols are exemplified:
polyester polyol (A) obtained by causing (II-1-a) polyvalent aliphatic alcohol having 2 to 9 carbon atoms, (II-2-a) a saturated aliphatic dicarboxylic acid, an aromatic dicarboxylic acid, or an acid anhydride thereof, and (II-3) a vegetable oil fatty acid to react with each other;
Polyester polyol (B) obtained by causing (II-1-a) polyvalent aliphatic alcohol having 2 to 9 carbon atoms, and (II-2-b) an unsaturated dicarboxylic acid or its anhydride to react with each other;
Polyester polyol (C) obtained by causing (II-1-a) polyvalent aliphatic alcohol having 2 to 9 carbon atoms, (II-2-b) an unsaturated dicarboxylic acid or its anhydride, and (II-3) a vegetable oil fatty acid to react with each other; and
Polyester polyol (D) obtained by causing (II-1-a) polyvalent aliphatic alcohol having 2 to 9 carbon atoms, (II-1-b) a castor oil, and (II-2-a) a saturated aliphatic dicarboxylic acid, an aromatic dicarboxylic acid, or an acid anhydride thereof to react with each other.

Here, examples of the (II-1-a) polyhydric aliphatic alcohol having 2 to 9 carbon atoms include ethylene glycol, neopentyl glycol, diethylene glycol, tetramethylene glycol, propylene glycol, dipropylene glycol, tripropylene glycol, 2,3,4-trimethyl-1,3-pentanediol, 3-methylpentene-1,5-diol, and 1,4-cyclohexanedimethanol. Among them, dipropylene glycol is particularly preferable from the aspect that it is possible to impart moderate flexibility to a coated film after coating, and an adhesive layer.

Examples of the saturated aliphatic dicarboxylic acid, an aromatic dicarboxylic acid, or an acid anhydride thereof (II-2-a) include a benzoic acid, a p-tert-butylbenzoic acid, an isophthalic acid, a phthalic anhydride, a terephthalic acid, an orthophthalic acid, a 2,6-naphthalene dicarboxylic acid, an azelaic acid, a sebacic acid, an isosebacic acid, an oxalic acid, a trimellitic acid, a (anhydrous) succinic acid, a (anhydrous) maleic acid, a fumaric acid, an (anhydrous) itaconic acid, a tetrahydro (anhydrous) phthalic acid, a hexahydro (anhydrous) phthalic acid, a hexahydro isophthalic acid, a hexahydro terephthalic acid, a glutaric acid, adipic acid, a pimeline acid, and a 1,4-cyclohexane dicarboxylic acid. Among them, anhydrous phthalic acid is particularly preferable in terms of moist-heat resistance.

Examples of the unsaturated dicarboxylic acid or its anhydride (II-2-b) include fumaric acid, maleic acid, and acid anhydrides thereof.

Examples of the vegetable oil fatty acid (II-3) include coconut oil fatty acid, sesame oil fatty acid, olive oil fatty acid, rapeseed oil fatty acid, soybean oil fatty acid, cacao oil fatty acid, and camellia oil fatty acid.

Among them, polyester polyol (C) which is obtained by reacting (II-1-a) polyvalent aliphatic alcohol having 2 to 9 carbon atoms, (II-2-b) unsaturated dicarboxylic acid or its anhydride, and (II-3) vegetable oil fatty acid with each other is particularly preferable in order to further improve the adhesion with the solar cell sealing material.

In the unsaturated double bond-containing polyester resin (II), a double bond equivalent is preferably from 100 to 1,000 g/eq. , and particularly from 200 to 800 g/eq. in order to realize the excellent adhesion with the sealing material in the adhesive coating material.

Further, in the unsaturated double bond-containing polyester polyol (II), a hydroxyl value is preferably from 10 to 350 mgKOH/g in order to obtain moderate crosslink density after curing and realize further improved adhesive strength. In addition, the weight average molecular weight (Mw) thereof is preferably from 3000 to 20000 in terms of the adhesive strength and the moist-heat resistance.

Note that, the number average molecular weight (Mn) of the hydroxyl group-containing acrylic resin (I) in the invention of the present application, and the weight average molecular weight (Mw) of the unsaturated double bond-containing polyester polyol (II) are the value measured by gel permeation chromatography (GPC) under the following conditions.

Measuring device; HLC-8220 GPC manufactured by Tosoh Corporation
Column; TSK-GUARDCOLUMN Super HZ-L manufactured by Tosoh Corporation
+ TSK-GEL Super HZM-M × 4 manufactured by Tosoh Corporation
Detector; RI (differential refractometer)
Data processing; Multi-station GPC-8020 model II manufactured by Tosoh Corporation
Measuring condition; Column temperature 40°C, Solvent Tetrahydrofuran, Flow rate 0.35 ml/mins
Standard; Monodisperse polystyrene
Sample; Material (100 µl) obtained by filtrating 0.2% by mass of tetrahydrofuran solution in terms of solid resin by using a microfilter

The mixing ratio of the hydroxyl group-containing (meth)acrylic resin (I) to the unsaturated double bond-containing polyester polyol (II) is preferably set such that the mass ratio [(I) / (II)] is from 95/5 to 50/50 in order to realize that the adhesion with the sealing material, the strength of the cured coated film, and the moist-heat resistance are excellent at the time of being used as an adhesive coating material.

In the polyol composition of the present invention, if a multifunctional epoxy compound (III) is used together with the above-described hydroxyl group-containing (meth)acrylic resin (I) and unsaturated double bond-containing polyester polyol (II), when the adhesive layer absorbs the moisture, it is possible to capture a carboxyl group generated by hydrolysis of the polyester polyol (A) by an epoxy group in the multifunctional epoxy compound (III), and thus the moist-heat resistance of the adhesive layer can be further improved.

The multifunctional epoxy compound (III) is preferably a hydroxyl group-containing epoxy compound having a molecular weight of 200 to 1,000. In other words, in a case where the molecular weight is equal to or greater than 200, in addition to the moist-heat resistance, the adhesive strength with respect to the base becomes further excellent, and in a case where the molecular weight is equal to or less than 1,000, the compatibility with the polyester polyol (II) becomes excellent.

Further, in the multifunctional epoxy compound (III), a hydroxyl value is preferably from 30 to 160 mgKOH/g, and further preferably from 50 to 150 mgKOH/g in order to obtain a resin composition with more excellent curability.

Examples of the multifunctional epoxy compound (III) include acyclic aliphatic polyglycidyl ethers such as 1,6-hexanediol diglycidyl ether, 1,4-butanediol diglycidyl ether, trimethylolpropane triglycidyl ether, and diethylene glycol diglycidyl ether; a cyclic aliphatic skeleton-containing epoxy compound such as cyclohexane dimethanol diglycidyl ether, 3',4'-epoxycyclohexylmethyl-3,4-epoxycyclohexane carboxylate, ε-caprolactone modified 3',4'-epoxycyclohexylmethyl-3,4-epoxycyclohexane carboxylate, hydrogenated product of bisphenol A type epoxy resin; a bisphenol type epoxy resin such as a bisphenol A type epoxy resin and a bisphenol F type epoxy resin; a biphenyl type epoxy resin such as tetramethylbiphenyl type epoxy resin; and a dicyclopentadiene-phenol addition reaction type epoxy resin. Each of these may be used alone or two or more types thereof may be used in combination. Among them, the trimethylolpropane triglycidyl ether and bisphenol type epoxy resin are preferable from the viewpoint that a resin composition excellent in base material adhesion and initial adhesive strength under moist-heat conditions can be obtained.

The mixing ratio of the multifunctional epoxy compound (III) is preferably from 4.0 to 30.0 parts by mass with respect to a total of 100 parts by mass of hydroxyl group-containing (meth)acrylic resin (I) and the unsaturated double bond-containing polyester polyol (II) which form the polyol composition of the present invention in terms of the moist-heat resistance and blocking resistance.

In the polyol composition of the present invention, a hydroxyl group-containing polycarbonate (IV) is used together with the hydroxyl group-containing (meth)acrylic resin (I) and the unsaturated double bond-containing polyester polyol (II) to remarkably improve the crosslink density of the cured object, and thus the adhesive strength and the moist-heat resistance can be further improved.

In the hydroxyl group-containing polycarbonate (IV) used of the present invention, the number average molecular weight (Mn) is preferably from 500 to 3,000 in order to improve the crosslink density at the time of curing with moderately high hydroxyl group concentration, and to realize the remarkable effect of improving the moist-heat resistance, and particularly, the number average molecular weight (Mn) is further preferably from 800 to 2,000. Note that, the number average molecular weight (Mn) is the value obtained by being measured under the same conditions as the GPC measuring conditions in the above-described new polyester polyol.

In the hydroxyl group-containing polycarbonate (IV), a hydroxyl value is preferably from 20 to 300 mgKOH/g in order to obtain a resin composition with more excellent curability, and particularly, the hydroxyl value is further preferably from 40 to 250 mgKOH/g. In addition, from the aspect that the base material adhesion is excellent under the moist-heat conditions, the hydroxyl group-containing polycarbonate is preferably polycarbonate diol.

Here, the hydroxyl group-containing polycarbonate (IV) can be prepared by a method of performing polycondensation reaction of polyhydric alcohol with a carbonylating agent.

Examples of the polyhydric alcohol used for preparing the hydroxyl group-containing polycarbonate (IV) include a linear alkanediol such as ethylene glycol, 1,3-propylene glycol, 1,4-butanediol, 1,5-pentanediol, 1,6-hexanediol, 1,8-nonanediol, and diethylene glycol; a branched alkanediol such as 1,2-propylene glycol, 1,3-butylene glycol, 2-methyl-1,3-propanediol, neopentyl glycol, 3-methyl-1,5-pentanediol, 2-n-butyl-2-ethyl-1,3-propanediol, 2,2-dimethyl-1,3-propanediol, 2,2-diethyl-1,3-propanediol, 2,4-diethyl-1,5-pentanediol, 1,2-hexane glycol, and 1,2-octyl glycol; an alicyclic diol such as 1,4-cyclohexanedimethanol; and a multifunctional alcohol having a tri-or higher functional branched alkane structure such as trimethylol propane and pentaerythritol.

In addition, examples of the carbonylating agent used for preparing the hydroxyl group-containing polycarbonate (IV) include phosgene, ethylene carbonate, propylene carbonate, dimethyl carbonate, diethyl carbonate, dibutyl carbonate, and diphenyl carbonate. Each of these may be used alone or two or more types thereof may be used in combination.

Among them, in terms of the compatibility, it is preferable to obtain by the reaction of diol selected from 1,4-butanediol, 1,5-pentanediol, 1,6-hexanediol, and 1,4-cyclohexanedimethanol with the carbonylating agent.

In a case of using the hydroxyl group-containing polycarbonate (IV), the mixing ratio is preferably from 2.0 to 30.0 parts by mass with respect to the total of 100 parts by mass of the hydroxyl group-containing (meth)acrylic resin (I) and the unsaturated double bond-containing polyester polyol (II) in the polyol composition of the present invention in order to realize a resinous coating material which is capable of maintaining the base material adhesion to be high even under the moist-heat conditions.

The polyol composition of the present invention may contain a hydroxyl group-containing compound (V) in addition to the hydroxyl group-containing (meth) acrylic resin (I), the unsaturated double bond-containing polyester polyol (II), and the multifunctional epoxy compound (III), and the hydroxyl group-containing polycarbonate (IV). Examples of the hydroxyl group-containing compound include polyester polyol obtained by causing a polybasic acid and polyhydric alcohol to react with each other, polyester polyurethane polyol obtained by causing a polybasic acid, polyhydric alcohol, and polyisocyanate to react with each other, linear polyester polyurethane polyol obtained by causing a dibasic acid, diol, and diisocyanate to react with each other, ether glycol such as polyoxyethylene glycol and polyoxypropylene glycol, bisphenols such as bisphenol A and bisphenol F, and an alkylene oxide adduct of bisphenols obtained by adding ethylene oxide, propylene oxide to the bisphenol. Each of these may be used alone or two or more types thereof may be used in combination.

The hydroxyl group-containing compound (V) can be used to the extent that the effects such as the adhesion to base sheet and the moist-heat conditions in the adhesive coating material of the present invention are not impaired, and specifically, in a range of equal to or less than 20% by mass with respect to the polyol composition of the present invention.

The above-described polyol composition may further contain various organic solvents. The organic solvent may be contained in a state where the solvents used at the time of synthesizing the respective resin components for forming the polyol composition remain in the polyol composition. Examples of the organic solvent include a ketone compounds such as acetone, methyl ethyl ketone (MEK), and methyl isobutyl ketone, a cyclic ether compound such as tetrahydrofuran (THF) and dioxolane, an ester compound such as methyl acetate, ethyl acetate, and n-butyl acetate, and aromatic compounds such as toluene and xylene. These may be used alone or two or more types thereof may be used in combination.

Here, it is possible to properly adjust the solid concentration of the polyol composition and the solid concentration of the adhesive coating material by using the organic solvent. The remaining amount of the organic solvents is not particularly limited, and for example, the solid concentration of the polyol component such as the hydroxyl group-containing (meth)acrylic resin (I) and unsaturated double bond-containing polyester polyol (II) is preferably from 40% to 70% by mass with respect to the polyol composition which is a main agent in order to adjust the adhesive coating material, and then realize coating workability thereafter.

The above-described polyol composition of the present invention can be used as the polyol component of the adhesive coating material of the present invention (hereinafter, a polyol composition of the present invention is denoted as a "polyol composition (α)"). Here, as the curing agent of the adhesive coating material, it is possible to use a polyisocyanate compound (β).

Examples of the polyisocyanate compound (β) used here include aliphatic polyisocyanate and aromatic polyisocyanate.

Examples of the aliphatic polyisocyanate include aliphatic diisocyanate or cycloaliphatic polyisocyanate such as 1,4-tetramethylene diisocyanate, 1,6-hexamethylene diisocyanate, 1,8-octamethylene diisocyanate, and L-lysine diisocyanate.

Examples of the cycloaliphatic polyisocyanate include cycloaliphatic diisocyanate such as hydrogenated 4,4'-diphenylmethane diisocyanate (hydrogenated MDI), isophorone diisocyanate, and norbornene diisocyanate.

Examples of the aromatic polyisocyanate include aromatic diisocyanate such as 4,4'-diphenylmethane diisocyanate (MDI), 4,4'-biphenyl diisocyanate tridene diisocyanate, 1,3-xylylene diisocyanate, 1,4-xylene diisocyanate, p-tetramethyl xylene diisocyanate, m-tetramethyl xylene diisocyanate, 2,4-tolylene diisocyanate, 2,6-tolylene diisocyanate, 1,5-naphthalene diisocyanate, m-phenylene diisocyanate, and p-phenylene diisocyanate.

In addition, tri-or higher functional polyisocyanate is also used, and specific examples include triphenylmethane triisocyanate, 1,6,11-undecane triisocyanate, 4,4',4"-triphenylmethane triisocyanate, 2,4,4'-biphenyl triisocyanate, 2,4,4'-diphenylmethane triisocyanate, and polymethylene phenyl isocyanate.

Further, examples thereof include isocyanurate type polyisocyanate, adduct type polyisocyanate, biuret type polyisocyanate, and uretdione type polyisocyanate which are obtained by using the polyisocyanate compound.

Among them, particularly, non-yellowing polyisocyanate such as aliphatic diisocyanate and alicyclic diisocyanate, the nurate type polyisocyanate, the biuret type polyisocyanate, and the uretdione type polyisocyanate are preferable in order to obtain a coated film excellent in appearance, and particularly, the nurate type polyisocyanate of aliphatic diisocyanate, the biuret type polyisocyanate of aliphatic diisocyanate, and the uretdione type polyisocyanate of aliphatic diisocyanate are preferable in terms of excellent yellowing resistance.

In terms of the adhesion with the sealing material, the strength of the cured coated film, and the moist-heat resistance, the mixing ratio of the polyol composition (α) to the polyisocyanate compound (β) is preferably set such that the equivalent ratio [NCO/OH] of the isocyanate group in the polyisocyanate compound (β) to the hydroxyl group in the polyol composition (α) is from 0.25 to 3.00.

Here, the hydroxyl group in the polyol composition (α) means not only a hydroxyl group in the hydroxyl group-containing (meth)acrylic resin (I) and the unsaturated double bond-containing polyester polyol (II), but also a hydroxyl group in the multifunctional epoxy compound (III) and the hydroxyl group-containing polycarbonate (IV) which are described blow, and a hydroxyl group in the hydroxyl group-containing compound (V).

The adhesive coating material of the invention of the present application may further contain various organic solvents. Examples of the solvent include a ketone compound such as acetone, methyl ethyl ketone (MEK), methyl isobutyl ketone, a cyclic ether compound such as tetrahydrofuran (THF) and dioxolane, an ester compound such as methyl acetate, ethyl acetate, and n-butyl acetate, and an aromatic compound such as toluene and xylene. These may be used alone or two or more types thereof may be used in combination.

In the present invention, after the polyol composition (α) which is a main agent and the polyisocyanate compound (β) which is a curing agent are preferably mixed, the organic solvents may be mixed for the purpose of adjusting the liquidity of the adhesive coating material to an optimum level as appropriate in response to the requirements of a coating device.

In a case of being used as an adhesive coating material for a solar cell back sheet, the adhesive coating material of the present invention can further contain various inorganic pigments, an organic pigment, or carbon black, a filler, an ultraviolet absorber, an antioxidants and/or light stabilizer. Such various mixing materials preferably form a premix which is premixed in the polyol composition (α) or the polyisocyanate compound (β), and the premix in the polyol composition (α) is preferable in terms of the workability.

Among the mixing materials, particularly, the titanium dioxide is preferably used as the inorganic pigment from the aspect that it is possible to improve the power generation efficiency of the solar cell by setting the surface of the solar cell back sheet to be white so as to make the sun light reflected on the surface, and in a case where design is emphasized, the carbon black is preferably mixed.

For example, as the titanium dioxide, the average particle diameter is preferably from 0.1 to 1.5 µm. The titanium dioxide having the average particle diameter of equal to or smaller than 1.5 µm has excellent surface smoothness of cured coated film, and thus is preferably used.

In accordance with the standard of the desired weather resistance, the titanium dioxide having an average particle diameter of 0.1 to 1.5 µm may be added to the main agent and/or the curing agent in consideration of the toughness of the cured coated film itself and the adhesion that can follow the flexibility of the substrate to be coated, the content is preferably from 25 to 900 parts by weight with respect to the total of 100 parts by weight in terms of the nonvolatile content of all curable components in order to realize excellent weather resistance, and is further preferably from 60 to 400 parts by weight in order to realize high whiteness as when fluororesin was used.

Further, the filler can be used as an anti-blocking agent, and specifically, examples thereof include silica, and resin beads which has an average particle diameter of 1 to 20 µm. The amount of the filler to be used is preferably from 0.1 to 10.0 parts by weight with respect to a total of 100 parts by weight in terms of the nonvolatile content of all curable components from the aspect that the blocking resistance can be imparted without deteriorating the adhesion performance.

As described above, when the base for a back sheet which protects the solar cell of the solar cell module is coated with the adhesive coating material of the present invention, it is possible to realize the excellent easy adhesion performance, and excellent adhesion and moist-heat resistance. In addition, in a case where the adhesive coating composition of the present invention is used for not only the back sheet, but also a transparent resin sheet substituting for a glass plate for protecting the solar cell surface, the base sheet of the sheet is coated, and thus it is possible to realize the easy adhesion performance of the solar cell sealing material.

In this regard, the coating amount of the adhesive coating material of the present invention with respect to the base sheet is not particularly limited; however, from the aspect that it is possible to impart the excellent weather resistance with a small coating amount, it is preferably, for example, from 1 to 20 g/m², and it is further preferably from 3 to 10 g/m². For example, a gravure coater, a micro gravure coater, a reverse coater, a bar coater, a roll coater, a die coater can be used as this coating.

The adhesive coating material of the present invention is used to realize the excellent adhesion performance with respect to the base sheet, and as necessary, it may be used to perform a surface treatment on the surface, on which a cured coated film is formed, of the base sheet such as a polyester resin film for the purpose of imparting further adhesive strength. Examples of the surface treatment include a corona treatment, a plasma treatment, an ozone treatment, a flame treatment, and a radiation treatment.

The base sheet for solar cell back sheet used here include a polyester resin sheet such as a polyethylene terephthalate sheet, a polybutylene terephthalate sheet, and polynaphthalene terephthalate; a polyolefin sheet such as a polyethylene sheet, a polypropylene sheet, and a polycyclopentadiene sheet, a fluororesin sheet such as a polyvinyl fluoride sheet, a polyvinylidene fluoride sheet, a polytetrafluoroethylene sheet, a tetrafluoroethylene-hexafluoropropylene copolymer (FEP) sheet, an ethylene-tetrafluoroethylene copolymer (ETFE) sheet, and an ethylene-tetrafluoro ethylene copolymer sheet; and an acrylic resin sheet such as polyacrylonitrile and polymethyl methacrylate. Among them, from the viewpoint of film rigidity and cost, a polyester resin sheet is preferable, and a polyethylene terephthalate sheet is particularly preferable.

The thickness of the base sheet for back sheet is not particularly limited, and for example, the thickness is preferably from 10 to 400 µm, and is further preferably from 80 to 300 µm from the aspect that the adhesive coating material of the present invention can exhibit excellent adhesion and impart the excellent weather resistance without any influence such warpage or wear on the base material by coating with a small amount of coating material and drying at a low temperature for a short period of time.

The base sheet for solar cell back sheet may have a structure of a single layer, or may be a multi-layer structure of two or more layers. Further, a vapor deposition film obtained by vapor-depositing a metal oxide or a nonmetallic inorganic oxide may be stacked.

Here, examples of the metal oxide or nonmetal inorganic oxide to be vapor-deposited include an oxide such as silicon, aluminum, magnesium, calcium, potassium, tin, sodium, boron, titanium, lead, zirconium, and yttrium. In addition, examples thereof include fluoride such as alkali metal and alkaline earth metal, and these can be used alone or in combination. Also, examples thereof include a material deposited by using a physical vapor deposition method such as vacuum vapor deposition and ion plating, or a chemical vapor deposition method such as plasma CVD.

In addition, the back sheet for solar cell of the present invention may be a sheet in which a film layer such as a metal foil or a weather-resistant resin layer, or a coating layer is disposed in a plurality of base sheets, and which has barrier properties.

Here, examples of the metal foil include a thin film such as aluminum, aluminum oxide, silicon oxide, tin oxide, and magnesium oxide. Among them, aluminum foil is preferable in terms of corrosion resistance. The thickness is preferably from 10 µm to 100 µm, and is further preferably from 20 µm to 50 µm. It is possible to use various conventionally known adhesives in the laminating of the metal foil.

Examples of the weather-resistant resin layer include a polyester resin film or a laminate obtained by laminating such as polyvinylidene fluoride film, polyethylene terephthalate, polybutylene terephthalate, and polynaphthalene terephthalate by using various types of adhesives in the related art, and a coated layer formed by applying a highly weather resistant coating material such as Lumiflon of Asahi Glass Co., Ltd.

As described above, the base sheet may be a sheet on which a vapor deposition film obtained by vapor-depositing a metal oxide or a nonmetallic inorganic oxide is laminated, or a sheet on which a film layer such as a metal foil or a weather-resistant resin layer, or a coating layer is disposed in a plurality of base sheets; however, in the present invention, it is possible to realize the excellent adhesive strength and moist-heat resistance only by coating the base sheet with the adhesive coating material, and thus it is preferable to use a base sheet formed of a single layer. When the base sheet formed of a single layer is used, it is possible to manufacture a sheet with high productivity while securing sufficient performance as a back sheet.

Next, in a case where the resin sheet for protecting solar cell surface is coated with the adhesive coating material of the present invention, similar to the case of the back sheet, examples of an available resin sheet for surface protection include a polyester resin sheet such as a polyethylene terephthalate sheet, a polybutylene terephthalate sheet, and polynaphthalene terephthalate; a polyolefin sheet such as a polyethylene sheet, a polypropylene sheet, and a polycyclopentadiene sheet; a fluororesin sheet such as a polyvinyl fluoride sheet, a polyvinylidene fluoride sheet, a polytetrafluoroethylene sheet, a tetrafluoroethylene-hexafluoropropylene copolymer (FEP) sheet, an ethylene-tetrafluoroethylene copolymer (ETFE) sheet, and an ethylene-tetrafluoroethylene copolymer sheet; an acrylic resin sheet such as polyacrylonitrile and polymethyl methacrylate; and polycarbonate. Among them, particularly in terms of transparency, a fluororesin sheet, a polyester resin sheet, an acrylic resin sheet, and polycarbonate are preferable. Among them, a fluororesin sheet, an acrylic resin sheet, and polycarbonate are preferable in terms of the weather-resistance, and a polyester resin sheet is an inexpensive material and advantages in terms of cost, and thus is preferable.

It is possible to manufacture the adhesive sheet of the present invention by coating the base sheet for back sheet specifically described above, or the base sheet for surface protection with the adhesive coating material of the present invention and curing the adhesive coating material.

Here, it is possible to perform the curing reaction under the conditions of a temperature of 25°C to 60°C for one to five days.

As illustrated in Fig. 1 which is a cross-sectional view of the solar cell module using the above-described adhesive sheet of the present invention, the module includes a solar cell (A), a surface protective base material (B), a sealing material for solar cell (D), and a back sheet (E) as essential components, in which the back sheet (E) includes a base sheet (a) and an adhesive layer (b) which is formed on the base sheet (a) and is a cured object of the adhesive coating material of the present invention as an essential layer configuration, and the back sheet (E) is disposed such that the adhesive layer (b) is in contact with the sealing material for solar cell (D) . Here, as described above, the surface protective base material (B) is formed of a resin sheet and a cured layer of the adhesive coating material of the present invention which is formed on the resin sheet, and may be a composite film disposed such that the cured layer is in contact with the sealing material (D).

In this regard, as described above, examples of the battery surface protective material (B) include a glass plate, a plastic board such as polycarbonate and polyacrylate. In a case of using the polycarbonate and polyacrylate, it is possible to realize the excellent adhesion by coating the surface being in contact with the sealing agent with the adhesive coating material of the present invention; however, in terms of the transparency, the weather resistance, and the toughness, the glass plate is preferable. Among the glass plates, white glass plate with high transparency is further preferable.

In addition, as the sealing agent (D) used for the solar cell module of the present invention, it is possible to use an ethylene vinyl acetate resin (EVA). When the organic peroxide is contained in the sealing agent (D), the crosslinking reaction of the adhesive coating material is promoted, and thus the sealing material (D) is preferably used.

In addition, examples of the solar cell (A) include a single crystal silicon type solar cell element, a polycrystalline silicon type solar cell element, an amorphous silicon type solar cell element composed of a single junction type, a tandem structure type, a III-V compound semiconductor solar cell element such as gallium arsenide (GaAs) or indium phosphide (InP), a II-VI compound semiconductor solar cell element such as cadmium tellurium (CdTe), a I-III-VI compound semiconductor solar cell element such as copper/indium/selenium (CIS), copper/indium/gallium/selenium (CIGS), and copper/indium/gallium/selenium/sulfur (CIGSS), a dye-sensitized solar cell element, and an organic solar cell element.

Examples of the method of producing the solar cell module include a method performed in such a manner that an ethylene vinyl acetate resin (EVA) sheet corresponding to a sealing material, a plurality of solar cells (A), an ethylene vinyl acetate resin (EVA) sheet, and the back sheet (E) of the present invention are disposed on a battery surface protective material (B), and are heated while being evacuated, and two of the EVA sheets are dissolved so as to seal a solar cell element. In this case, a plurality of the solar cell elements are bonded to each other in series via an interconnector (C).

### Examples

Hereinafter, the present invention will be more specifically described with reference to Examples.

Note that, in examples of the present application, the number average molecular weight (Mn) and the weight average molecular weight (Mw) were measured based on gel permeation chromatography (GPC) under the following conditions.

Measuring device; HLC-8220 GPC manufactured by Tosoh Corporation
Column; TSK-GUARDCOLUMN Super HZ-L manufactured by Tosoh Corporation
+ TSK-GEL Super HZM-M × 4 manufactured by Tosoh Corporation
Detector; RI (differential refractometer)
Data processing; Multi-station GPC-8020 model II manufactured by Tosoh Corporation
Measuring condition; Column temperature 40°C, Solvent Tetrahydrofuran, Flow rate 0.35 ml/mins
Standard; Monodisperse polystyrene
Sample; Material (100 µl) obtained by filtrating 0.2% by mass of tetrahydrofuran solution in terms of solid resin by using a microfilter

### Preparation example 1 <Synthesis of acrylic resin (1)>

50 parts by mass of xylene and 16 parts by mass of n-butyl acetate were put into a four-necked flask including a thermometer, a stirrer, a reflux condenser, and a nitrogen gas introduction pipe, the mixture was stirred, and a temperature was increased up to 115°C in a nitrogen atmosphere. When the temperature was increased up to the aforementioned temperature, a mixture of 44.0 parts by mass of methyl methacrylate, 40.0 parts by mass of isobutyl methacrylate, 15.0 parts by mass of 2-hydroxyethyl methacrylate, and 1.0 parts by mass of methacrylic acid, and 0.8 parts by mass of perbutyl O (t-butylperoxy-2-ethylhexanoate, prepared by NOF CORPORATION) were diluted in 15 parts by mass of xylene, and the resultant was added dropwise for five hours. Thereafter, the reaction was continuously performed at the same temperature, the resultant was added to dropwise, and after one hour, 42 parts by mass of xylene, 10 parts by mass of normal butyl acetate, and 0.1 parts by mass of Perhexa C (1,1-di(t-butyl peroxy) cyclohexane, prepared by NOF CORPORATION) were put into the resultant.

After the additional input, the reaction was continuously performed at the same temperature for five hours. Thereafter, the temperature was cooled down to room temperature so as to obtain an organic solvent solution of an acrylic resin (1) having 45% by mass of nonvolatile content. The obtained property value of the acrylic resin (1) is indicated in Table 1.

### Preparation example 2 <Synthesis of acrylic resin (2)>

46 parts by mass of toluene was put into a four-necked flask including a thermometer, a stirrer, a reflux condenser, and a nitrogen gas introduction pipe, the mixture was stirred, and a temperature was increased up to 105°C in a nitrogen atmosphere. When the temperature was increased up to the aforementioned temperature, a mixture of 20.0 parts by mass of methyl methacrylate, 5.0 parts by mass of isobutyl acrylate, 69.5 parts by mass of cyclohexyl methacrylate, 5.0 parts by mass of 2-hydroxyethyl methacrylate, and 0.5 parts by mass of methacrylic acid, 0.5 parts by mass of perbutyl O (t-butylperoxy-2-ethylhexanoate, prepared by NOF CORPORATION), and 0.5 parts by mass of perbutyl Z (t-butyl peroxybenzoate, prepared by NOF CORPORATION) were diluted in 20 parts by mass of toluene, and the resultant was added dropwise for four hours.

After adding dropwise, the reaction was continuously performed at the same temperature for five hours. Thereafter, toluene and ethyl acetate were added and the temperature was cooled down to room temperature so as to obtain an organic solvent solution of an acrylic resin (2) having 50% by mass of nonvolatile content. The obtained property value of the acrylic resin (2) is indicated in Table 1.

### Preparation example 3 <Synthesis of acrylic resin (3)>

18.0 parts by mass of methyl methacrylate, 78.0 parts by mass of n-butyl methacrylate, 2.0 parts by mass of 2-hydroxyethyl methacrylate, 2.0 parts by mass of glycidyl methacrylate, and 100 parts by mass of toluene were put into a four-necked flask including a thermometer, a stirrer, a reflux condenser, and a nitrogen gas introduction pipe, the mixture was stirred while a temperature was increased up to 100°C, 0.15 parts by mass of azobisisobutyronitrile was added thereto and polymerized for two hours, 0.07 parts by mass of azobisisobutyronitrile was further added thereto and polymerized for two hours, 0.07 parts by mass of azobisisobutyronitrile was further added thereto, and the mixture was reacted for two hours.

Subsequently, 0.03 parts by mass of hydroquinone, 0.8 parts by mass of dimethyl benzylamine, and 1.0 parts by mass of acrylic acid were added to the resultant, and reacted at 100°C for 15 hours so as to obtain organic solvent solution of an acrylic resin (3) having 50% by mass of nonvolatile content. The obtained property value of the acrylic resin (3) is indicated in Table 1.

### Preparation example 4 <Synthesis of acrylic resin (4)>

18.0 parts by mass of methyl methacrylate, 80.0 parts by mass of n-butyl methacrylate, 2.0 parts by mass of 2-hydroxyethyl methacrylate, and 100 parts by mass of toluene were put into a four-necked flask including a thermometer, a stirrer, a reflux condenser, and a nitrogen gas introduction pipe, the mixture was stirred while a temperature was increased up to 100°C, 0.15 parts by mass of azobisisobutyronitrile was added thereto and polymerized for two hours, 0.07 parts by mass of azobisisobutyronitrile was further added thereto and polymerized for two hours, 0.07 parts by mass of azobisisobutyronitrile was further added thereto, and the mixture was reacted for two hours. Thereafter, the temperature was cooled down to the room temperature so as to obtain an organic solvent solution of an acrylic resin (4) having 50% by mass of nonvolatile content.

The obtained property value of the acrylic resin (4) is indicated in Table 1.

**[Table 1]**

| | Hydroxyl value (mgKOH/g) | Tg (°C) | Number average molecular weight |
|---|---|---|---|
| Acrylic resin (1) | 65 | 75 | 12,000 |
| Acrylic resin (2) | 20 | 65 | 22,000 |
| Acrylic resin (3) | 17.2 | 30 | 39,000 |
| Acrylic resin (4) | 9 | 31 | 36,000 |

### Preparation example 5 <Synthesis of polyester resin (1)>

17 parts by mass of trimethylolpropane, 42 parts by mass of dipropylene glycol, 35 parts by mass of fumaric acid, 6 parts by mass of coconut oil fatty acid, and 0.2 parts by mass of organic titanium compound were put into a flask including a stirring rod, a temperature sensor, and a rectification tube, and the temperature was heated up to 210°C while dry nitrogen was caused to flow into the flask and stirred so as to perform an esterification reaction. When an acid value was equal to or less than 5.0 mgKOH/g, the reaction was stopped, the temperature was cooled down to 100°C, the mixture was diluted by ethyl acetate so as to adjust the solid content to be 80% by mass, and thereby polyester polyol (A1) having the weight average molecular weight (Mw) of 12,000, gardner viscosity of U-V, the hydroxyl value of the solid content of 220 mgKOH/g, and the double bond equivalent of 300 g/eq was obtained.

### Preparation example 6 <Synthesis of polyester resin (2)>

8 parts by mass of ethylene glycol, 12 parts by mass of pentaerythritol, 40 parts by mass of anhydrous phthalic acid, 40 parts by mass of castor oil, and 0.2 parts by mass of organic titanium compound were put into a flask including a stirring rod, a temperature sensor, and a rectification tube, and the temperature was heated up to 210°C while dry nitrogen was caused to flow into the flask and stirred so as to perform an esterification reaction. When an acid value was equal to or less than 5.0 mgKOH/g, the reaction was stopped, the temperature was cooled down to 100°C, the mixture was diluted by ethyl acetate so as to adjust the solid content to be 80% by mass, and thereby polyester polyol (2) having the weight average molecular weight (Mw) of 16,000, gardner viscosity of U-V, the hydroxyl value of the solid content of 120 mgKOH/g, and the double bond equivalent of 700 g/eq was obtained.

### Preparation example 7 <Synthesis of polyester resin (3)>

40 parts by mass of trimethylolpropane, 16 parts by mass of neopentyl glycol, 25 parts by mass of anhydrous phthalic acid, 19 parts by mass of fumaric acid, and 0.2 parts by mass of organic titanium compound were put into a flask including a stirring rod, a temperature sensor, and a rectification tube, and the temperature was heated up to 210°C while dry nitrogen was caused to flow into the flask and stirred so as to perform an esterification reaction. When an acid value was equal to or less than 5.0 mgKOH/g, the reaction was stopped, the temperature was cooled down to 100°C, the mixture was diluted by ethyl acetate so as to adjust the solid content to be 80% by mass, and thereby polyester polyol (3) having the weight average molecular weight (Mw) of 4,700, gardner viscosity of U-V, the hydroxyl value of the solid content of 270 mgKOH/g, and the double bond equivalent of 550 g/eq was obtained.

### Preparation example 8 <Synthesis of polyester resin (4)>

15 parts by mass of trimethylolpropane, 32 parts by mass of 1,3-butanediol, 9 parts by mass of anhydrous phthalic acid, 45 parts by mass of adipic acid, and 0.2 parts by mass of organic titanium compound were put into a flask including a stirring rod, a temperature sensor, and a rectification tube, and the temperature was heated up to 210°C while dry nitrogen was caused to flow into the flask and stirred so as to perform an esterification reaction. When an acid value was equal to or less than 5.0 mgKOH/g, the reaction was stopped, the temperature was cooled down to 100°C, the mixture was diluted by ethyl acetate so as to adjust the solid content to be 80% by mass, and thereby polyester polyol (4) having the weight average molecular weight (Mw) of 12,000, gardner viscosity of U-V, and the hydroxyl value of the solid content of 170 mgKOH/g was obtained.

**[Table 2]**

| | Hydroxyl value (solid content) (mgKOH/g) | Double bond equivalent (g/eq) |
|---|---|---|
| Polyester resin (1) | 220 | 300 |
| Polyester resin (2) | 120 | 700 |
| Polyester resin (3) | 270 | 550 |
| Polyester resin (4) | 170 | None |

### Examples 1 to 18 and Comparative Examples 1 to 8

A main agent component was adjusted in accordance with the mixing ratio indicated in Tables 3 to 7. Thereafter, a curing agent was mixed to the main agent (a catalyst was further mixed in Comparative Examples 5 to 8), and was adjusted to be 30% by mass of solid concentration with ethyl acetate so as to obtain an adhesive coating material (the mixing amount indicated in Tables 3 to 7 is the values in terms of the solid content).

Abbreviations in each table are as follows.
N-3300: an isocyanurate body of 1,6-hexamethylene diisocyanate ("Sumidur N-3300" prepared by Sumika Bayer Urethane Co., Ltd., the content of isocyanate group (NCO): 21.8% by mass, viscosity: 2500 mPa·s/25°C)
N-3200: a biuret body of 1,6-hexamethylene diisocyanate ("Desmodur N-3200" prepared by Sumika Bayer Urethane Co., Ltd. , the content of isocyanate group (NCO): 23.0% by mass, viscosity: 2100 mPa·s/25°C)
N-3400: a uretdione body of 1,6-hexamethylene diisocyanate ("Desmodur N-3400" prepared by Sumika Bayer Urethane Co., Ltd., the content of isocyanate group (NCO): 21.8% by mass, viscosity: 175 mPa·s/25°C)
TSE-100: an isocyanurate body of 1,6-hexamethylene diisocyanate ("Duranate TSE-100" prepared by Asahi Kasei Corporation, the content of isocyanate group (NCO): 12.1% by mass, viscosity: 1650 mPa·s/25°C)
T5651: polycarbonate diol ("Duranol" prepared by Asahi Kasei Chemicals Corporation, a polycarbonate resin obtained from 1,5-pentanediol and 1,6-hexanediol, number average molecular weight: 1,000, hydroxyl value: 100 to 120 mgKOH/g)
UM-90: polycarbonate diol ("Ethanacol" prepared by Ube Industries, Ltd., number average molecular weight: approximately 900, a mixture in which the mass ratio of polycarbonate diol obtained by reacting 1,6-hexanediol with a carbonate ester, and polycarbonate diol obtained by reacting 1,4-cyclohexanedimethanol with carbonate ester is 1:3) EX-321: a mixture of diglycidyl ether of trimethylolpropane and triglycidyl ether ("Denacol EX-321" prepared by Nagase ChemteX Corporation, epoxy equivalent: 140 g/eq.)
860-80SE: bisphenol A type epoxy resin ("EPICLON 860-80SE" (prepared by DIC Corporation, epoxy equivalent: 250 g/eq., ethyl acetate cut product, solid content: 80% by mass) JER828: bisphenol A type epoxy resin ("JER828" prepared by Mitsubishi Chemical Corporation, epoxy equivalent: 190 g/eq.) JR-403: titanium oxide ("JR-403" prepared by Tayca Corporation)
M-215: isocyanuric acid EO modified diacrylate ("Aronix M-215" prepared by Toagosei Co., Ltd.)
Polyisocyanate compound *¹: isocyanurate body of hexamethylene diisocyanate blocked with 3,5-dimethylpyrazole (ethyl acetate solution having a solid content of 75% by mass)

Next, the polyethylene terephthalate film ("DS-10" manufactured by Sichuan Dongfang Insulating Material Co., Ltd.) was coated with the adhesive coating material which was obtained in the respective examples and comparative examples such that the coating amount after drying is from 3 to 4 g/m², and dried at 120°C for 30 seconds so as to form an adhesive layer, and the formed adhesive layer was subjected to aging at 40°C for three days, thereby obtaining an adhesive laminated film including an easy adhesive layer.

The obtained adhesive laminated film was cut into a width of 80 mm and a length of 200 mm so as to obtain an adhesive laminated film for evaluation.

One EVA sheet which was cut into a width of 80 mm and a length of 70 mm was prepared, the EVA sheet was interposed between two of the adhesive laminated films for evaluation such that the easy adhesive layer is in contact with the EVA sheet, then, the laminated layer was evacuated performed at 150°C for five minutes by using a vacuum laminator device so as to set the pressure to be approximately 133 Pa, and thereafter, the laminated layer was pressed at 150°C for 15 minutes at the pressure of 0.1 MPa, thereby obtaining a laminate for evaluation.

The evaluation for the adhesion and moist-heat resistance was performed by using a sample obtained by cutting the obtained laminate for evaluation into a width of 10 mm. The results are indicated in Tables 3 to 7.

### [Adhesion strength evaluation method]

The peeling test was performed on the laminate for evaluation by clamping an unbonded part between upper and lower clips of a tensile tester (manufactured by A&D Company, Limited), at a crosshead speed of 100 mm/min and 180 degrees. The obtained measured value was evaluated as follows.
A: Equal to or greater than 50 N/10 mm
B: Equal to or greater than 30 N/10 mm and less than 50 N/10 mm
C: Equal to or greater than 10 N/10 mm and less than 30 N/10 mm
D: Less than 10 N/10 mm

### [Method of evaluating moist-heat resistance]

The laminate for evaluating adhesive strength was subjected to a pressure cooker test (PCT) for 24 hours and 48 hours (test condition: temperature of 121°C and relative humidity of 100%), and the peel strength after conducting a moist-heat resistance test was measured under the same conditions.

Examples 1-3, 7-11 and 15-17 are for reference only.

**[Table 3]**

| | | | | Example 1 | Example 2 | Example 3 | Example 4 | Example 5 | Example 6 |
|---|---|---|---|---|---|---|---|---|---|
| Adhesive composition | Main agent | Hydroxyl group-containing acrylic resin (I) | Acryl (1) | 24 | 24 | 24 | 24 | 24 | 24 |
| | | | Acryl (2) | | | | | | |
| | | Polyester resin (II) | Polyester (1) | 7.9 | 7.9 | 7.9 | 7.9 | 7.9 | 7.9 |
| | | | Polyester (2) | | | | | | |
| | | | Polyester (3) | | | | | | |
| | | Epoxy compound (III) | EX-321 | | | 3 | 3 | | |
| | | | 860-80SE | | | 2.4 | | 2.4 | |
| | | Polycarbonate diol (IV) | T5651 | | | | 3 | 3 | 3 |
| | | | UM-90 | | | | | | |
| | | Coloring agent | JR-403 | | 24 | 24 | 24 | 24 | 24 |
| | | | Carbon black | | | | | | |
| | Curing agent | Polyisocyanate compound (β) | N3300 | 12.5 | 12.5 | 12.5 | 13.5 | 13.5 | 13.5 |
| | | | N3200 | | | | | | |
| | | | N3400 | | | | | | |
| | | | TSE-100 | | | | | | |
| Evaluation | | Adhesion | | A | A | A | A | A | A |
| | | Moist-heat resistance (PCT 24 hr) | | A | A | A | A | A | A |
| | | Moist-heat resistance (PCT 48 hr) | | B | C | B | A | A | A |

**[Table 4]**

| | | | | Example 7 | Example 8 | Example 9 | Example 10 | Example 11 | Example 12 | Example 13 |
|---|---|---|---|---|---|---|---|---|---|---|
| Adhesive composition | Main agent | Hydroxyl group-containing acrylic resin (I) | Acryl (1) | 24 | 24 | 24 | 24 | 24 | 24 | 24 |
| | | | Acryl (2) | | | | | | | |
| | | Polyester resin (II) | Polyester (1) | 5.2 | 2.6 | 7.9 | 7.9 | 7.9 | 7.9 | 7.9 |
| | | | Polyester (2) | | | | | | | |
| | | | Polyester (3) | | | | | | | |
| | | Epoxy compound (III) | EX-321 | 3 | 3 | 3 | 3 | 3 | 3 | 3 |
| | | | 860-80SE | 2.4 | 2.4 | 2.4 | 2.4 | 2.4 | 2.4 | 2.4 |
| | | Polycarbonate diol (IV) | T5651 | | | | | | 3 | 3 |
| | | | UM-90 | | | | | | | |
| | | Coloring agent | JR-403 | 24 | 24 | 24 | 24 | 24 | 24 | 24 |
| | | | Carbon black | | | | | | | |
| | Curing agent | Polyisocyanate compound (β) | N3300 | 10.5 | 8.5 | | | | 16.5 | 20 |
| | | | N3200 | | | 12 | | | | |
| | | | N3400 | | | | 12.5 | | | |
| | | | TSE-100 | | | | | 23 | | |
| Evaluation | | Adhesion | | A | A | A | A | A | A | A |
| | | Moist-heat resistance (PCT 24 hr) | | A | A | A | A | B | A | A |
| | | Moist-heat resistance (PCT 48 hr) | | B | B | B | B | B | A | A |

**[Table 5]**

| | | | | Example 14 | Example 15 | Example 16 | Example 17 | Example 18 |
|---|---|---|---|---|---|---|---|---|
| Adhesive composition | Main agent | Hydroxyl group-containing acrylic resin (I) | Acryl (1) | 24 | | | 24 | 24 |
| | | | Acryl (2) | | 24 | 24 | | |
| | | Polyester resin (II) | Polyester (1) | 6.6 | 15.7 | | | 6.6 |
| | | | Polyester (2) | | | 15.7 | | |
| | | | Polyester (3) | | | | 15.7 | |
| | | Epoxy compound (III) | EX-321 | 2 | 3 | 3 | 3 | 3 |
| | | | 860-80SE | 2.4 | 2.4 | 2.4 | 2.4 | 2.4 |
| | | Polycarbonate diol (IV) | T5651 | | | | | |
| | | | UM-90 | 3 | | | | 3 |
| | | Coloring agent | JR-403 | 24 | 24 | 24 | 24 | |
| | | | SPECIAL BLACK 100 | | | | | 24 |
| | Curing agent | Polyisocyanate compound (β) | N3300 | 12.5 | 6.5 | 6.5 | 6.5 | 12.5 |
| | | | N3200 | | | | | |
| | | | N3400 | | | | | |
| | | | TSE-100 | | | | | |
| Evaluation | | Adhesion | | A | A | A | A | A |
| | | Moist-heat resistance (PCT 24 hr) | | A | A | A | A | A |
| | | Moist-heat resistance (PCT 48 hr) | | A | C | C | C | A |

**[Table 6]**

| | | | | Comparative Example 1 | Comparative Example 2 | Comparative Example 3 | Comparative Example 4 |
|---|---|---|---|---|---|---|---|
| Adhesive composition | Main agent | Hydroxyl group-containing acrylic resin (I) | Acryl (1) | 24 | | | |
| | | | Acryl (2) | | 24 | 24 | 24 |
| | | Polyester resin | Polyester (4) | | | | 7.9 |
| | | Epoxy compound (III) | EX-321 | 3 | 3 | 3 | 3 |
| | | | 860-80SE | 2.4 | 2.4 | 2.4 | 2.4 |
| | | Coloring agent | JR-403 | 24,0 | 24 | 24 | 24 |
| | Curing agent | Polyisocyanate compound (β) | N3300 | 10.5 | 6.5 | 3.3 | 6.5 |
| Evaluation | | Adhesion | | C | C | C | C |
| | | Moist-heat resistance (PCT 24 hr) | | C | C | C | C |
| | | Moist-heat resistance (PCT 48 hr) | | C | C | C | C |

**[Table 7]**

| | | | | Comparative Example 5 | Comparative Example 6 | Comparative Example 7 | Comparative Example 8 |
|---|---|---|---|---|---|---|---|
| Adhesive composition | Main agent | Acrylic copolymer | Acryl (3) | 100 | | 100 | |
| | | | Acryl (4) | | 100 | | 100 |
| | | Acryloyl group-containing compound | M-215 | | 5 | | 5 |
| | | Epoxy compound (III) | JER828 | | | 30 | 30 |
| | Curing agent | Polyisocyanate compound *1 | | 18 | 9.5 | 24.6 | 12.9 |
| | Catalyst | Dibutyltin dilaurate | | 0.01 | 0.01 | 0.01 | 0.01 |
| Evaluation | | Adhesion | | B | B | B | B |
| | | Moist-heat resistance (PCT 24 hr) | | C | C | C | C |
| | | Moist-heat resistance (PCT 48 hr) | | C | C | C | C |

### Reference Signs List

A: SOLAR CELL
B: SURFACE PROTECTIVE BASE MATERIAL
C: INTERCONNECTOR
D: SEALING MATERIAL
E: BACK SHEET
F: TERMINAL
a: BASE SHEET
b: ADHESIVE LAYER WHICH IS CURED OBJECT OF ADHESIVE COATING MATERIAL

## Claims

1. A polyol composition for a polyisocyanate curing-type adhesive coating material, comprising, as essential components:
a hydroxyl group-containing (meth)acrylic resin (I);
unsaturated double bond-containing polyester polyol (II); and
a hydroxyl group-containing polycarbonate (IV).

2. The polyol composition for a polyisocyanate curing-type adhesive coating material according to claim 1,
wherein the hydroxyl group-containing (meth)acrylic resin (I) is obtained by copolymerizing hydroxyl group-containing (meth)acrylate (a) and other (meth)acrylic monomers (b) as essential components.

3. The polyol composition for a polyisocyanate curing-type adhesive coating material according to claim 2,
wherein the hydroxyl group-containing (meth)acrylic resin (I) is obtained by using the hydroxyl group-containing (meth)acrylate (a), (meth)acrylate (b-1) esterified with an alkyl group having 1 to 3 carbon atoms, and (meth)acrylate (b-2) esterified with an alkyl group having 4 to 16 carbon atoms as the essential monomer components, and copolymerizing the hydroxyl group-containing (meth)acrylate (a), the (meth)acrylate (b-1) esterified with an alkyl group having 1 to 3 carbon atoms, and (meth)acrylate (b-2) esterified with an alkyl group having 4 to 16 carbon atoms such that content ratios thereof are in a range of 3% to 20% by mass, 15% to 50% by mass, and 30% to 76%, respectively, by mass with respect to the monomer components for forming the hydroxyl group-containing (meth)acrylic resin (I).

4. The polyol composition for a polyisocyanate curing-type adhesive coating material according to claim 1,
wherein a mass ratio [(I)/(II)] of the hydroxyl group-containing (meth)acrylic resin (I) to the unsaturated double bond-containing polyester polyol (II) is from 95/5 to 50/50.

5. The polyol composition for a polyisocyanate curing-type adhesive coating material according to claim 1, further comprising an epoxy resin (III) in addition to the hydroxyl group-containing (meth)acrylic resin (I) and the unsaturated double bond-containing polyester polyol (II) .

6. The polyol composition for a polyisocyanate curing-type adhesive coating material according to claim 5,
wherein a mixing ratio of the epoxy resin (III) is from 4.0 to 30.0 parts by mass with respect to a total of 100 parts by mass of the hydroxyl group-containing (meth)acrylic resin (I) and the unsaturated double bond-containing polyester polyol (II) which are the essential components of the polyol composition.

7. The polyol composition for a polyisocyanate curing-type adhesive coating material according to claim 1,
wherein a mixing ratio of the hydroxyl group-containing polycarbonate (IV) is from 2.0 to 30.0 parts by mass with respect to a total of 100 parts by mass of the hydroxyl group-containing (meth)acrylic resin (I) and the unsaturated double bond-containing polyester polyol (II) which are the essential components of the polyol composition.

8. The polyol composition for a polyisocyanate curing-type adhesive coating material according to claim 1, further comprising titanium dioxide in addition to the hydroxyl group-containing (meth)acrylic resin (I) and the unsaturated double bond-containing polyester polyol (II).

9. The polyol composition for a polyisocyanate curing-type adhesive coating material according to any one of claims 1 to 8,
wherein the unsaturated double bond-containing polyester polyol (II) comprises at least one unsaturated dicarboxylic acid or anhydride thereof selected from the group consisting of fumaric acid, maleic acid, fumaric acid anhydride, maleic acid anhydride, coconut oil fatty acid, sesame oil fatty acid, olive oil fatty acid, rapeseed oil fatty acid, soybean oil fatty acid, cacao oil fatty acid, and camellia oil fatty acid, as a raw material.

10. An adhesive coating material comprising, as essential components:
the polyol composition (α) according to any one of claims 1 to 9; and
a polyisocyanate compound (β).

11. The adhesive coating material according to claim 10,
wherein a mixing ratio of the polyol composition (α) to the polyisocyanate compound (β) is set such that an equivalent ratio [NCO/OH] of an isocyanate group in the polyisocyanate compound (β) to a hydroxyl group in the polyol composition (α) is from 0.25 to 3.00.

12. A cured object which is obtained by curing the adhesive coating material according to claim 10.

13. An adhesive sheet comprising a polyester base sheet having thereon an adhesive layer formed by coating the polyester base sheet with the adhesive coating material according to claim 10 and curing the adhesive coating material.

14. A solar cell module comprising, as essential components:
a solar cell (A);
a surface protective base material (B);
a sealing material for solar cell (D); and
a back sheet (E),
wherein the back sheet (E) includes a base sheet (a) and an adhesive layer (b) which is formed on the base sheet (a) and is a cured object of the adhesive coating material according to claim 10 as an essential layer configuration, and
wherein the back sheet (E) is disposed such that the adhesive layer (b) is in contact with the sealing material for solar cell (D).

## Patentansprüche

1. Polyolzusammensetzung für ein Klebstoffbeschichtungsmaterial des Polyisocyanat-Härtungstyps, umfassend, als wesentliche Komponenten:
ein Hydroxylgruppen enthaltendes (Meth)acrylharz (I);
ungesättigte Doppelbindungen enthaltendes Polyesterpolyol (II) und
ein Hydroxylgruppen enthaltendes Polycarbonat (IV).

2. Polyolzusammensetzung für ein Klebstoffbeschichtungsmaterial des Polyisocyanat-Härtungstyps gemäß Anspruch 1,
wobei das Hydroxylgruppen enthaltende (Meth)acrylharz (I) durch Copolymerisieren von Hydroxylgruppe enthaltendem (Meth)acrylat (a) und anderen (Meth)acrylmonomeren (b) als essentielle Komponenten erhalten wird.

3. Polyolzusammensetzung für ein Klebstoffbeschichtungsmaterial des Polyisocyanat-Härtungstyps gemäß Anspruch 2,
wobei das Hydroxylgruppen enthaltende (Meth)acrylharz (I) erhalten wird, indem das Hydroxylgruppe enthaltende (Meth)acrylat (a), (Meth)acrylat (b-1), verestert mit einer Alkylgruppe mit 1 bis 3 Kohlenstoffatomen, und (Meth)acrylat (b-2), verestert mit einer Alkylgruppe mit 4 bis 16 Kohlenstoffatomen, als die essentiellen Monomerkomponenten verwendet werden und das Hydroxylgruppe enthaltende (Meth)acrylat (a), das (Meth)acrylat (b-1), verestert mit einer Alkylgruppe mit 1 bis 3 Kohlenstoffatomen, und (Meth)acrylat (b-2), verestert mit einer Alkylgruppe mit 4 bis 16 Kohlenstoffatomen, so copolymerisiert werden, dass die Gehaltsverhältnisse davon in einem Bereich von 3 bis 20 Massen-%, 15 bis 50 Massen-% bzw. 30 bis 76 Massen-% bezüglich der Monomerkomponenten zur Bildung des Hydroxylgruppen enthaltenden (Meth)acrylharzes (I) sind.

4. Polyolzusammensetzung für ein Klebstoffbeschichtungsmaterial des Polyisocyanat-Härtungstyps gemäß Anspruch 1,
wobei das Massenverhältnis [(I)/(II)] des Hydroxylgruppen enthaltenden (Meth)acrylharzes (I) zu dem ungesättigte Doppelbindungen enthaltenden Polyesterpolyol (II) 95/5 bis 50/50 ist.

5. Polyolzusammensetzung für ein Klebstoffbeschichtungsmaterial des Polyisocyanat-Härtungstyps gemäß Anspruch 1, die außerdem ein Epoxyharz (III) zusätzlich zu dem Hydroxylgruppen enthaltenden (Meth)acrylharz (I) und dem ungesättigte Doppelbindungen enthaltenden Polyesterpolyol (II) umfasst.

6. Polyolzusammensetzung für ein Klebstoffbeschichtungsmaterial des Polyisocyanat-Härtungstyps gemäß Anspruch 5,
wobei der Mischungsverhältnisanteil des Epoxyharzes (III) 4,0 bis 30,0 Massenteile, bezogen auf insgesamt 100 Massenteile des Hydroxylgruppen enthaltenden (Meth)acrylharzes (I) und des ungesättigte Doppelbindungen enthaltenden Polyesterpolyols (II), welche die essentiellen Komponenten der Polyolzusammensetzung sind, ist.

7. Polyolzusammensetzung für ein Klebstoffbeschichtungsmaterial des Polyisocyanat-Härtungstyps gemäß Anspruch 1,
wobei der Mischungsverhältnisanteil des Hydroxylgruppen enthaltenden Polycarbonats (IV) 2,0 bis 30,0 Massenteile, bezogen auf insgesamt 100 Massenteile des Hydroxylgruppen enthaltenden (Meth)acrylharzes (I) und des ungesättigte Doppelbindungen enthaltenden Polyesterpolyols (II), welche die essentiellen Komponenten der Polyolzusammensetzung sind, ist.

8. Polyolzusammensetzung für ein Klebstoffbeschichtungsmaterial des Polyisocyanat-Härtungstyps gemäß Anspruch 1, die außerdem Titandioxid zusätzlich zu dem Hydroxylgruppen enthaltenden (Meth)acrylharz (I) und dem ungesättigte Doppelbindungen enthaltenden Polyesterpolyol (II) umfasst.

9. Polyolzusammensetzung für ein Klebstoffbeschichtungsmaterial des Polyisocyanat-Härtungstyps gemäß einem der Ansprüche 1 bis 8,
wobei das ungesättigte Doppelbindungen enthaltende Polyesterpolyol (II) wenigstens eine ungesättigte Dicarbonsäure oder ein Anhydrid davon, ausgewählt aus der Gruppe, bestehend aus Fumarsäure, Maleinsäure, Fumarsäureanhydrid, Maleinsäureanhydrid, Kokosnussölfettsäure, Sesamölfettsäure, Olivenölfettsäure, Rapsölfettsäure, Sojabohnenölfettsäure, Kakaoölfettsäure und Kamelienölfettsäure, als Ausgangsmaterial umfasst.

10. Klebstoffbeschichtungsmaterial, umfassend als essentielle Komponenten:
die Polyolzusammensetzung (α) gemäß einem der Ansprüche 1 bis 9 und
eine Polyisocyanatverbindung (β).

11. Klebstoffbeschichtungsmaterial gemäß Anspruch 10,
wobei das Mischungsverhältnis der Polyolzusammensetzung (α) zu der Polyisocyanatverbindung (β) so eingestellt ist, dass ein Äquivalentverhältnis [NCO/OH] einer Isocyanatgruppe in der Polyisocyanatverbindung (β) zu einer Hydroxylgruppe in der Polyolzusammensetzung (α) 0,25 bis 3,00 beträgt.

12. Gehärteter Gegenstand, der durch Härten des Klebstoffbeschichtungsmaterials gemäß Anspruch 10 erhalten wird.

13. Klebefolie, umfassend eine Polyesterbasisfolie, die darauf eine Klebstoffschicht hat, die durch Beschichten der Polyesterbasisfolie mit dem Klebstoffbeschichtungsmaterial gemäß Anspruch 10 und Härten des Klebstoffbeschichtungsmaterials gebildet wurde.

14. Solarzellenmodul, umfassend als essentielle Komponenten:
eine Solarzelle (A);
ein Oberflächenschutzbasismaterial (B);
ein Dichtungsmaterial für Solarzelle (D) und
eine Rückwandfolie (E),
wobei die Rückwandfolie (E) eine Basisfolie (a) und eine Klebstoffschicht (b), die auf der Basisschicht (a) gebildet ist und ein gehärteter Gegenstand des Klebstoffbeschichtungsmaterials gemäß Anspruch 10 ist, als essentiellen Schichtaufbau umfasst, und
wobei die Rückwandfolie (E) so angeordnet ist, dass die Klebstoffschicht (b) mit dem Dichtungsmaterial für die Solarzelle (D) in Kontakt ist.

## Revendications

1. Composition de polyol pour une matière de revêtement adhésif de type polyisocyanate à durcissement, comprenant, comme composants essentiels :
une résine (méth)acrylique contenant des groupes hydroxyle (I) ;
un polyol de polyester contenant une double liaison insaturée (II) ; et
un polycarbonate contenant des groupes hydroxyles (IV)

2. Composition de polyol pour une matière de revêtement adhésif de type polyisocyanate à durcissement selon la revendication 1,
dans laquelle la résine (méth)acrylique contenant des groupes hydroxyle (I) est obtenue par copolymérisation de (méth)acrylate contenant des groupes hydroxyle (a) et d'autres monomères (méth)acryliques (b) en tant que composants essentiels.

3. Composition de polyol pour une matière de revêtement adhésif de type polyisocyanate à durcissement selon la revendication 2,
dans laquelle la résine (méth)acrylique (I) contenant des groupes hydroxyle est obtenue en utilisant le (méth)acrylate contenant des groupes hydroxyle (a), le (méth)acrylate (b-1) estérifié avec un groupe alkyle ayant 1 à 3 atomes de carbone, et le (méth)acrylate (b-2) estérifié avec un groupe alkyle ayant 4 à 16 atomes de carbone comme composants monomères essentiels, et en copolymérisant le (méth)acrylate contenant des groupes hydroxyle (a), le (méth)acrylate (b-1) estérifié avec un groupe alkyle ayant 1 à 3 atomes de carbone, et le (méth)acrylate (b-2) estérifié avec un groupe alkyle ayant 4 à 16 atomes de carbone de telle sorte que les rapports de teneur de ceux-ci se situent dans une plage de 3 % à 20 % en masse, 15 % à 50 % en masse, et 30 % à 76 %, respectivement, en masse par rapport aux composants monomères pour former la résine (méth)acrylique contenant des groupes hydroxyle (I).

4. Composition de polyol pour une matière de revêtement adhésif de type polyisocyanate à durcissement selon la revendication 1,
dans laquelle un rapport massique [(I) / (II)] de la résine (méth)acrylique contenant des groupes hydroxyle (I) au polyol de polyester contenant une double liaison insaturée (II) est de 95/5 à 50/50.

5. Composition de polyol pour une matière de revêtement adhésif de type polyisocyanate à durcissement selon la revendication 1, comprenant en outre une résine époxy (III) en plus de la résine (méth)acrylique contenant des groupes hydroxyle (I) et du polyol de polyester contenant une double liaison insaturée (II).

6. Composition de polyol pour une matière de revêtement adhésif de type polyisocyanate à durcissement selon la revendication 5,
dans laquelle un rapport de mélange de la résine époxy (III) est de 4,0 à 30,0 parties en masse par rapport à un total de 100 parties en masse de la résine (méth)acrylique contenant des groupes hydroxyle (I) et du polyol de polyester contenant une double liaison insaturée (II) qui sont les composants essentiels de la composition de polyol.

7. Composition de polyol pour une matière de revêtement adhésif du type polyisocyanate à durcissement selon la revendication 1,
dans laquelle un rapport de mélange du polycarbonate contenant des groupes hydroxyle (IV) est de 2,0 à 30,0 parties en masse par rapport à un total de 100 parties en masse de la résine (méth)acrylique contenant des groupes hydroxyle (I) et du polyol de polyester contenant une double liaison insaturée (II) qui sont les composants essentiels de la composition de polyol.

8. Composition de polyol pour une matière de revêtement adhésif de type polyisocyanate à durcissement selon la revendication 1, comprenant en outre du dioxyde de titane en plus de la résine (méth)acrylique contenant des groupes hydroxyle (I) et du polyol de polyester contenant une double liaison insaturée (II).

9. Composition de polyol pour une matière de revêtement adhésif de type polyisocyanate à durcissement selon l'une quelconque des revendications 1 à 8,
dans laquelle le polyol de polyester contenant une double liaison insaturée (II) comprend au moins un acide dicarboxylique insaturé ou un anhydride de celui-ci choisi dans le groupe constitué de l'acide fumarique, l'acide maléique, l'anhydride de l'acide fumarique, l'anhydride de l'acide maléique, l'acide gras d'huile de noix de coco, l'acide gras d'huile de sésame, l'acide gras d'huile d'olive, l'acide gras d'huile de colza, l'acide gras d'huile de soja, l'acide gras d'huile de cacao et l'acide gras d'huile de camélia, en tant que matière première.

10. Matière de revêtement adhésif comprenant, en tant que composants essentiels :
ladite composition de polyol (α) selon l'une quelconque des revendications 1 à 9 ; et
un composé de polyisocyanate (β).

11. Matière de revêtement adhésif selon la revendication 10,
dans laquelle un rapport de mélange de la composition de polyol (α) au composé polyisocyanate (β) est établi de telle sorte que le rapport équivalent (NCO/OH) d'un groupe isocyanate dans le composé polyisocyanate (β) à un groupe hydroxyle dans la composition de polyol (α) est de 0,25 à 3,00.

12. Objet durci qui est obtenu par durcissement de la matière de revêtement adhésif selon la revendication 10.

13. Feuille adhésive comprenant une feuille de base en polyester sur laquelle se trouve une couche adhésive formée en revêtant la feuille de base en polyester avec la matière de revêtement adhésif selon la revendication 10 et en durcissant la matière de revêtement adhésif.

14. Module de cellule solaire comprenant, comme composants essentiels :
une cellule solaire (A) ;
une matière de base de protection de surface (B) ;
une matière d'étanchéité pour la cellule solaire (D) ; et
une feuille arrière (E),
dans lequel la feuille arrière (E) comprend une feuille de base (a) et une couche adhésive (b) qui est formée sur la feuille de base (a) et est un objet durci de la matière de revêtement adhésif selon la revendication 10 comme configuration de couche essentielle, et
dans lequel la feuille arrière (E) est disposée de telle sorte que la couche adhésive (b) est en contact avec la matière d'étanchéité pour la cellule solaire (D).
